# EUROPÄISCHE PATENTSCHRIFT

(11) **EP 3 531 137 B1**
(45) Veröffentlichungstag und Bekanntmachung des Hinweises auf die Patenterteilung: **28.10.2020**
(21) Anmeldenummer: 18158615.7
(22) Anmeldetag: 26.02.2018
(51) Int. Cl.: G01R 17/10, H02J 1/06

(54) **ENERGIEVERSORGUNGSVORRICHTUNG UND VERFAHREN ZUM BETREIBEN EINER ENERGIEVERSORGUNGSVORRICHTUNG**
ENERGY SUPPLY DEVICE AND METHOD FOR OPERATING SAME
DISPOSITIF D'ALIMENTATION EN ÉNERGIE ET PROCÉDÉ DE FONCTIONNEMENT D'UN DISPOSITIF D'ALIMENTATION EN ÉNERGIE

(43) Veröffentlichungstag der Anmeldung: 28.08.2019
(73) Patentinhaber: Thales Management & Services Deutschland GmbH, 71254 Ditzingen (DE)
(72) Erfinder: ZURFLUH, Erwin Alex, 8706 Meilen (CH); SCHWEHN, Oliver, 71636 Ludwigsburg (DE)
(74) Vertreter: Kohler Schmid Möbus Patentanwälte

(56) Entgegenhaltungen:
- EP-A1- 3 247 015
- WO-A1-2016/206843
- DE-A1-102010 030 821

## Beschreibung

### Hintergrund der Erfindung

Die Erfindung betrifft eine Energieversorgungseinrichtung zur Versorgung von Verbrauchern mit Energie umfassend eine erste Speisung, einen Energiebus mit einer 2-poligen Busleitung und Busankoppelelementen, wobei zwei Busankoppelelemente jeweils ein Bussegment der Busleitung begrenzen und wobei die Busankoppelelemente jeweils ein erstes Schaltelemente-Paar zur elektrischen Trennung der Busleitung umfassen. Die Erfindung betrifft auch ein Verfahren zum Betreiben einer Energieversorgungseinrichtung.

Eine derartige Energieversorgungseinrichtung ist bekannt aus EP 3 247 015 A1. Ein Verfahren zum Ermitteln einer Leitungsstörung innerhalb eines Energiebusses ist aus WO 2016/206843 und DE102010030821 bekannt.

Ein "Energiebus" bezeichnet eine aufeinanderfolgende Anordnung mehrerer Verbraucher entlang einer (2-poligen) Busleitung mit einer gemeinsamen Einspeisung. Der Energiebus der bekannten Energieversorgungseinrichtung umfasst neben der Busleitung auch Verbraucher-Busankoppelelemente, die entlang der Busleitung, also hintereinander, angeordnet sind und die Busleitung in Bussegmente unterteilt, sowie je nach Anzahl der Speisungen (Gleichspannungsquellen) Einspeise-Busankoppelelemente, über die Strom von der(den) Speisung(en) in die Busleitung eingespeist werden kann. Ein Energiebus kann eine lineare (offene Busleitung) oder eine ringförmige (geschlossene Busleitung) Topologie aufweisen. Der Stromfluss innerhalb des Energiebusses erfolgt bidirektional.

Die Verbraucher-Busankoppelelemente weisen Schaltelemente zur elektrischen Trennung der Busleitung auf, so dass die Busankoppelelemente jeweils in einen Grundzustand und/oder einen ersten Betriebszustand, in dem die Busleitung durch das entsprechende Verbraucher-Busankoppelelement (Busankoppelelement mit Anschluss für Verbraucher) elektrisch unterbrochen ist, und in einen zweiten Betriebszustand, in dem die Bussegmente durch das entsprechende Verbraucher-Busankoppelelement elektrisch verbunden sind, gebracht werden können. Die Verbraucher-Busankoppelelemente sind i.A. funktionell unabhängig von den jeweiligen Verbrauchern. Es können auch Busankoppelelemente vorhanden sein, die keinen Verbraucher versorgen. Die Busankoppelelemente bilden Unterbrechungsstellen, an denen die Busleitung unterbrochen werden kann. Bei der Trennung/Unterbrechung der Busleitung handelt es sich um das Fehlen einer elektrisch leitenden Verbindung zwischen benachbarten Bussegmenten. Im Spannungspotentialbereich der Betriebsspannung wird hierdurch eine elektrische Isolierung erreicht.

Das Trennen der Busleitung in mehrere Busleitungsabschnitte (Bussegmente) durch die Verbraucher-Busankoppelelemente (elektrisches Unterbrechen der Busleitung an Unterbrechungsstellen) ermöglicht ein sequentielles Anschalten der Verbraucher und somit eine Reduzierung der auftretenden Stromspitzen beim Anschalten der Verbraucher (Busaufbau). Im Falle eines defekten Segments der Busleitung (z.B. Kurzschluss), werden die Verbraucher-Busankoppelelemente des betreffenden Versorgungssektors in den ersten Betriebszustand versetzt. Der Energiebus, bzw. der betroffene Versorgungssektor muss dann neu hochgefahren werden. Während dieser Zeit können die in diesem Versorgungssektor angeschlossenen Verbraucher nicht durch das Einspeise-Busankoppelelemente mit Energie versorgt werden.

In der Leit- und Sicherungstechnik bei Bahnen werden spannungsführende Leitungen in der Außenanlage in aller Regel als IT-Netz ausgeführt (IT - isolee terre). Das heißt, die elektrischen Potentiale der spannungsführenden Leiter sind in etwa um das Erdpotential zentriert. Bei einem ersten Kurzschluss von einem Leiter nach Erdpotential verschiebt sich das Potential des anderen Leiters gegenüber dem Erdpotential und dem jeweils anderen Leiter, doch das System ist weiterhin uneingeschränkt funktionstauglich. Bei zwei spannungsführenden Leitern in einem IT Netz, gibt es im Wesentlichen drei Arten von Kurzschlüssen: Kurzschlüsse der einzelnen Leiter gegen Erdpotential und den direkten Kurzschluss der spannungsführenden Leiter.

Bei herkömmlichen Energieversorgungseinrichtungen mit Energiebussen ist ein in der Versorgungsleitung zugeschaltetes Gerät (Erdschlusswächter, z.B. Bender UG145) vorgesehen, das eine eventuell auftretende Potentialverschiebung erkennt und einen Alarm generiert. Aktualisierte Vorschriften, insbesondere DIN EN 61557-8, verlangen heute eine Isolationsüberwachung mit Ausgabe eines Widerstandswertes. Diese Geräte (z.B. Bender iso685) arbeiten mit einem Verfahren, das mit Pulsen das IT-Netz beaufschlagt und aus der Netzantwort mit einem Prozessor den Isolationswert errechnet. Dieses aufwendige Verfahren ist für Netze mit hohen elektrischen Kapazitäten geeignet, doch ist das Verfahren langsam und kostenaufwendig. Zudem kann ohne aufwändige externe Sensorik nicht festgestellt werden wo genau im Energiebus die Störung aufgetreten ist.

Aus WO 2016/206843 A1 ist ein Verfahren zur automatischen Kurzschlussbeseitigung in einem Energiebus mit mehreren Netzknoteneinheiten bekannt. Jede Netzknoteneinheit misst den Bussstrom und die Stromrichtung. Bei Überschreibung eines Grenzwertes wird der Energiebus gestaffelt abgeschaltet. Nachteilig an diesem Verfahren ist, dass bei hohen Netzkapazitäten (Eingangskondensatoren der Schaltnetzteile von vielen Netzknoten) ein selektives Abschalten im Millisekunden Takt kaum möglich ist und damit die zulässige Speisungslücke überschritten werden kann.

Darüber hinaus wird ein übergeordnetes Steuersystem benötigt, um mit den dezentralen Funktionseinheiten (Verbrauchern) mittels Datentelegramme Informationen auszutauschen.

### Aufgabe der Erfindung

Es ist Aufgabe der Erfindung, eine Vorrichtung und ein Verfahren vorzuschlagen, wodurch einerseits ein Energiebus schnell und störungsfrei in Betrieb genommen werden kann und ein eventuell vorhandenes gestörtes Bussegment im Busaufbau schon gar nicht zugeschaltet wird.

Durch die nachfolgend beschriebene Erfindung kann bei einem sich im Betrieb befindlichen Energiebus bei Eintritt einer Störung das gestörte Bussegment umgehend isoliert werden und der Energiebus bzw. die von der Störung nicht betroffenen Bussegmente können schnell und sicher wieder hochgefahren werden, so dass Ausfallzeiten der Verbraucher des Energiebusses minimiert oder sogar verhindert werden können.

### Beschreibung der Erfindung

Diese Aufgabe wird erfindungsgemäß gelöst durch eine Energieversorgungsvorrichtung nach Anspruch 1 und ein Verfahren nach Anspruch 7.

Bei der erfindungsgemäßen Energieversorgungsvorrichtung dient zur Überprüfung des Bussegments eines der das zu überprüfende Bussegment begrenzenden Busankoppelelemente als Referenz-Busankoppelelement und das andere als Prüf-Busankoppelelement. Erfindungsgemäß umfassen die Busankoppelelemente jeweils drei Brückenwiderstände, die zwischen positiver Potentialseite und negativer Potentialseite der Busleitung miteinander in Serie geschaltet sind, und zwei Überbrückungswiderstände, die jeweils ein Schaltelement des ersten Schaltelement-Paars überbrücken. Die erfindungsgemäße Energieversorgungsvorrichtung weist zum Ermitteln von Leitungsstörungen eine doppelte Wheatstone'sche Brückenschaltung mit einem Referenzbrückenzweig, einem Prüfbrückenzweig und zwei Indikatorbrückenzweige, auf, wobei der Referenzbrückenzweig die drei Brückenwiderstände des Referenz-Busankoppelelements umfasst, und wobei der Prüfbrückenzweig die drei Brückenwiderstände des Prüf-Busankoppelelements sowie die Überbrückungswiderstände des Referenz-Busankoppelelements umfasst.

Erfindungsgemäß ist eine doppelte Brückenschaltung in der Busleitung verschaltet, derart, dass die Elemente der doppelten Brückenschaltung auf zwei Busankoppelelemente aufgeteilt ist, so dass eines der Busankoppelelemente (nämlich das der Speisung elektrisch näher gelegene) als Referenz-Busankoppelelement dient. Mit der erfindungsgemäßen Schaltung können sowohl Kurzschlüsse innerhalb des Energiebusses als auch Kurzschlüsse gegen Erdpotential ermittelt werden. Der Begriff "Kurzschlüsse" beinhaltet sowohl niederimpedante Ableitungen, die den Nennstrom des Bussystems überschreiten, als auch relativ kleine Ströme gegen Erdpotential, die die Isolationsvorgaben überschreiten.

Das zu überprüfendes Bussegment wird durch ein vorgeschaltetes Busankoppelelement (Referenz-Busankoppelelement) und einem nachgeschalteten Busankoppelelement (Prüf-Busankoppelelement) begrenzt.

Die Brückenwiderstände innerhalb jedes Referenz- oder Prüf-Brückenzweigs sind in Serie geschaltet und umfassen daher einen mittleren Brückenwiderstand und zwei äußere Brückenwiderstände.

Das Prinzip der doppelten Brückenschaltung basiert darauf, dass die Widerstandsverhältnisse im Referenzbrückenzweig gleich den Widerstandsverhältnissen im Prüfbrückenzweig sind. Dies kann erreicht werden, indem die Widerstandswerte so gewählt werden, dass der mittlere Brückenwiderstand und zwei äußere Brückenwiderstände den gleichen Widerstandswert aufweisen und dass der Wert des Überbrückungswiderstands gleich der Summe der Werte der Brückenwiderstände entspricht. Bei einer Busleitung mit einer hohen Anzahl an Busankoppelelementen kann es vorteilhaft sein, wenn die mittleren Brückenwiderstände größer gewählt werden als die äußeren Brückenwiderstände (s.u.). Die Widerstandswerte werden wie folgt gewählt: Verhältnis des Widerstandswerts des äußeren Brückenwiderstands einer Potentialseite zu der Summe der Widerstandswerte des mittleren und des äußeren Brückenwiderstands der anderen Potentialseite ist gleich dem Verhältnis des Widerstandswerts des Überbrückungswiderstands der einen Potentialseite zu der Summe der Widerstandswerte der Brückenwiderstände und dem Überbrückungswiderstand der anderen Potentialseite. Aufgrund der erfindungsgemäßen Verwendung einer Brückenmessmethode kann die Prüfung weitgehend unabhängig von der an den Busankoppelelementen anliegenden Spannung durchgeführt werden.

Die Doppelbrücke umfasst zwei Indikatorzweige, welche jeweils einen Prüfpunkt des Prüfbrückenzweigs mit einem Referenzpunkt des Referenzbrückenzweigs verbindet. Jeder Indikatorzweig umfasst eine Spannungsmesseinrichtung, welches den Potentialunterschied (Brückenspannung) zwischen dem jeweiligen Prüfpunkt und dem zugehörigen Referenzpunkt ermittelt. Der Prüfpunkt des ersten (bzw. zweiten) Indikatorzweigs liegt zwischen dem äußeren Brückenwiderstand des Prüf-Busankoppelelements und dem Überbrückungswiderstand des Referenz-Busankoppelelements der positiven (bzw. negativen) Potentialseite der Busleitung. Der Referenzpunkt des ersten (bzw. zweiten) Indikatorzweigs liegt zwischen dem mittleren und dem äußeren (an der positiven (bzw. negativen) Potentialseite der Busleitung angeordneten) Brückenwiderstand des Referenz-Busankoppelelements. Durch Messung der Brückenspannungen kann auf schnelle und einfache Weise ermittelt werden, ob eine Störung und welche Art der Störung vorliegt.

Vorzugsweise umfasst die erfindungsgemäße Vorrichtung eine Vielzahl an Busankoppelelementen und daran angeschlossenen Verbrauchern, wobei jeweils zwei benachbarte Busankoppelelemente (Busankoppelelemente-Paare) eine doppelte Wheatstone'sche Brückenschaltung umfassen, mittels der das Bussegment zwischen dem Prüf-Busankoppelelement und dem Referenz-Busankoppelelement überprüft werden kann.

Die Verbraucher-Busankoppelelemente können von zwei Richtungen mit Energie versorgt werden, bspw. mittels zweier Speisungen. Die doppelten Brückenschaltungen sind vorzugsweise bzgl. der beiden Einspeiserichtungen symmetrisch aufgebaut, so dass jedes Busankoppelelement eines Busankoppelelemente-Paars sowohl als Prüf-Busankoppelelement als auch als Referenz-Busankoppelelement für das jeweilige zu überprüfende Bussegment fungieren kann (abhängig von der Speisungsrichtung). Jedes Bussegment kann dann also aus beiden Richtungen überprüft werden.

Vorzugsweise wird die erfindungsgemäße Vorrichtung innerhalb eines Netzes der Netzform IT (isolée terre) verwendet, d.h. die elektrischen Potentiale der spannungsführenden Leiter der Busleitung haben definitionsgemäß keinen Bezug zum Erdpotential, kann aber in der Praxis mit symmetrischen hochohmigen Widerständen etwa um das Erdpotential zentriert werden. Diese Netzform wird vorzugsweise in der Bahntechnik, insbesondere in der Leit- und Sicherungstechnik verwendet.

Das Prüf-Busankoppelelement ist ein Verbraucher-Busankoppelelement, d.h. ein Busankoppelelement, das dazu eingerichtet ist, dass ein Verbraucher angeschlossen werden kann. Es wird also das Bussegment überprüft, das für die Stromzuführung zu einem Verbraucher-Busankoppelelement führt, um sicherzustellen, dass ein an diesem Busankoppelelement angeschlossener Verbraucher sicher betrieben werden kann. Als Referenz-Busankoppelelement kann ein Speise-Busankoppelelement oder ein Verbraucher-Busankoppelelement dienen.

Das Verbraucher-Busankoppelelement umfasst Schaltelemente zur elektrischen Trennung der Busleitung, so dass die Busankoppelelemente jeweils in einen Grundzustand und/oder in einen ersten Betriebszustand, in dem die Busleitung durch das entsprechende Verbraucher-Busankoppelelement elektrisch unterbrochen ist, und in einen zweiten Betriebszustand, in dem die Bussegmente durch das entsprechende Verbraucher-Busankoppelelement elektrisch verbunden sind, gebracht werden können.

Vorzugsweise sind die Verbraucher zumindest teilweise mit einem lokalen Energiespeicher ausgestattet. Beim Überprüfen der Bussegmente kann sich der Verbraucher aus dem lokalen Energiespeicher mit Energie versorgen bis die Prüfung abgeschlossen ist. Auf diese Weise wird der Betrieb der Verbraucher nicht unterbrochen.

Bei einer besonders vorteilhaften Ausführungsform ist die Busleitung mit einer weiteren Speisung elektrisch verbunden. Die Verbraucher-Busankoppelelemente können von verschiedenen Richtungen über verschiedene Speisungen mit Energie versorgt werden. Hierdurch wird ein beidseitiges Einspeisen von Energie auch bei einer linearen Bus-Topologie ermöglicht.

Bei einer speziellen Ausführungsform weist der mittlere Brückenwiderstand der in Serie geschalteten Brückenwiderstände eine höheren Widerstandswert auf als die beiden äußeren Brückenwiderstände, insbesondere einen um einen Faktor 1,2 bis 1,5 höheren Widerstandswert. Hierdurch kann eine bessere Symmetrierung der Doppelbrücke erreicht werden.

In der Leit- und Sicherungstechnik kann in den IT-Netzen- in Abhängigkeit der Sicherheitsbetrachtung - eine Isolationsmessung vorgeschrieben werden, diese dient zum Erkennen eines ersten Fehlers bevor ein zweiter Fehler eintritt.

Zur Durchführung der Isolationsmessung ist es vorteilhaft, wenn ein oder mehrere Isolationsüberwachungsgerät(e) zur Durchführung von Isolationsmessungen an den Bussegmenten und/oder den einzelnen Einspeise-Busankoppelelementen und eine Diagnoseeinheit zur Steuerung der Isolationsmessungen vorhanden sind. Die zentrale Diagnoseeinheit zur Steuerung der Isolationsmessungen kann funktionell für einen oder mehrere Versorgungssektoren zuständig sein. Mit der zentralen Diagnoseeinheit und den verteilten Isolationsüberwachungsgeräten können gezielt quantitative Messungen an ausgewählten Bussegmenten durchgeführt werden. Durch die Segmentierung des Energiebusses können bei beidseitig gespeisten Energiebussen die Isolationsmessungen während des Betriebs des Energiebusses durchgeführt werden. Dazu wird ein zu vermessender Versorgungssektor des Energiebusses vom im Betrieb befindlichen Energiebus getrennt (Unterbrechen eines Bussegments an den beiden begrenzenden Verbraucher-Busankoppelelementen) und geprüft. Die Durchführung dieser Messungen während des Betriebs des Energiebusses ist besonders vorteilhaft, da diese Messungen sehr zeitaufwändig sein können.

Falls eine Diagnoseeinheit für den Betrieb des Energiebusses eingesetzt wird, ist diese vorzugsweise zentralisiert und Teil eines übergeordneten Systems für den Betrieb der Leit- und Sicherungstechnik. Die verteilten Geräte zur Isolationsmessung (Isolationsüberwachungsgeräte) können aber müssen nicht Teil einer Einspeisevorrichtung sein (insbesondere wenn mehrere Speisungen vorgesehen sind). Die Einspeiseeinrichtung umfasst vorzugsweise mindestens folgende Teilsysteme: eine Gleichspannungsquelle (Speisung), ein erstes Referenz-Busankoppelelement, einen Kontrollprozessor zur Kontrolle des Einspeise-Busankoppelelementes und einen Betriebsprozessor zur Steuerung der Gleichspannungsquelle und das Isolationsüberwachungsgerät (falls vorhanden). Die zentrale Diagnoseeinheit kommuniziert über ein parallel geführtes Datennetz mit allen erreichbaren Einspeise-Busankoppelelemente und Verbraucher-Busankoppelelemente in einem bestimmten Versorgungssektor (Versorgungssektor = Energieversorgungsbereich innerhalb des Energiebusses mit einer oder mehreren Speisungen und einer Vielzahl von Verbraucher-Busankoppelelemente und den dazwischenliegenden Bussegmenten).

Vorzugsweise ist mindestens ein Verbraucher an einem der Busankoppelelemente angeschlossen, wobei es sich bei den Verbrauchern vorzugsweise um Komponenten der Leit- und Sicherungstechnik, insbesondere um Feldelemente handelt. Feldelemente sind Elemente, die entlang einer Schienenverkehrsstrecke angeordnet sind, insbesondere Weichen, Signale usw. Die Feldelemente umfassen vorzugsweise jeweils eine Weitbereichs-Stromversorgung, diverse Elektronik mit Prozessoren und einen Anschluss an das Datenkommunikationsnetzwerk.

Bei einer speziellen Ausführungsform der erfindungsgemäßen Energieversorgungseinrichtung ist die erste Speisung die einzige Speisung des Energiebusses. Dabei kann beispielsweise lediglich das erste Verbraucher-Busankoppelelement direkt (also ohne Zwischenschaltung eines weiteren mit einem Verbraucher bestückten Verbraucher-Busankoppelelements) mit der ersten Speisung bzw. dem Einspeise-Busankoppelelement verbunden sein. Die weiteren Verbraucher-Busankoppelelemente schließen sich dann jeweils an das vorangehende Verbraucher-Busankoppelelement an (Einspeisepunkt an einem der beiden Enden des Energiebusses). Die Einspeisung von Strom erfolgt hier nur an einer einzigen Stelle. Bei einer Störung werden der ganze Energiebus oder Teile des Busses stromlos. Es ist jedoch auch möglich, die erste Speisung an einer beliebigen Stelle des Energiebusses, z.B. zwischen zwei Verbraucher-Busankoppelelementen anzuordnen. Die Einspeisung von Energie in die Busleitung erfolgt dann von der einzigen Speisung in zwei Richtungen.

Eine weitere Ausführungsform der erfindungsgemäßen Stromversorgungseinrichtung sieht vor, dass das erste und das n-te (letzte) Verbraucher-Busankoppelelement direkt mit der ersten Speisung verbunden sind, so dass der Energiebus eine ringförmige Topologie aufweist. Diese Ausführungsform ermöglicht eine beidseitige Einspeisung von Strom mittels nur einer Speisung. Hierdurch können trotz Auftreten eines Fehlers in einem Segment der Busleitung sämtliche Verbraucher mit Energie versorgt werden (Fehlerbehebung erster Stufe).

Vorzugsweise ist die Busleitung mit einer weiteren (also einer zweiten, ev. auch einer dritten, vierten usw.) Speisung elektrisch verbunden (dritte und fünfte Ausführungsform).

Bei der dritten vorteilhaften Ausführungsform ist einer der Verbraucher-Busankoppelelemente, vorzugsweise das n-te Verbraucher-Busankoppelelement direkt mit der weiteren (insbesondere der zweiten) Speisung verbunden. Bei dieser Ausführungsform weist der Energiebus eine lineare Topologie mit einer beidseitigen Einspeisung von Energie mittels zweier Speisungen auf.

Zum Zwecke einer erhöhten Verfügbarkeit ist es vorteilhaft, wenn mehr als eine weitere Speisung (also insgesamt mehr als zwei Speisungen) mit der Busleitung elektrisch verbunden sind (dritte und fünfte Ausführungsform).

Ab dieser Ausführungsform kann eine Fehlerbehebung erster und fallweiser zweiter Stufe realisiert werden.

Besonders vorteilhaft ist es, wenn eine Buskoppeleinheit vorhanden ist, die den ersten Energiebus mit einem zweiten Energiebus koppelt. Eine Buskoppeleinheit verfügt über mindestens vier Anschlüsse (Kopplung von zwei Energiebussen) und kann beliebige elektrisch zulässige Stellungen (also insbesondere kurzschlussfreie paarweise Kopplungen der zweipoligen Busleitungen) einnehmen, auch Mehrfachstellungen .

Über dieselbe Koppeleinheit können auch mehr als zwei Energiebusse miteinander gekoppelt werden. Darüber hinaus kann die Energieversorgungseinrichtung auch mehrere Koppeleinheiten umfassen, die jeweils mindestens zwei Energiebusse miteinander koppeln.

Im Falle einer ringförmigen Topologie des/der Energiebusses/busse teilt die Buskoppeleinheit die ringförmige(n) Busleitung(en) benachbarter Energiebusse jeweils in einen ersten Leitungsabschnitt und einen zweiten Leitungsabschnitt. Bei Auftreten einer Störung sowohl im ersten Leitungsabschnitt als auch im zweiten Leitungsabschnitt eines Energiebusses können dann die durch die buseigene Speisung nicht mehr versorgbaren Verbraucher durch die Speisung des zweiten Busses versorgt werden (Fehlerbehebung zweiter Stufe). Die Buskoppeleinheit umfasst dazu bspw. weitere Schaltelemente zum elektrischen Verbinden des nicht mehr versorgbaren Leitungsabschnitts des ersten Energiebusses mit dem zweiten Energiebus.

Eine vierte Ausführungsform sieht dabei vor, dass der erste und der zweite Energiebus (vorzugsweise sämtliche Energiebusse der Energieversorgungseinrichtung) eine ringförmige Topologie aufweisen. Diese Ausführungsform ist insbesondere vorteilhaft, wenn große Distanzen mit hoher Verfügbarkeit überwunden werden müssen, bspw. zur Verbindung zweier Versorgungsnetze.

Eine fünfte und sechste Ausführungsform sieht vor, dass der erste und der zweite Energiebus (vorzugsweise sämtliche Energiebusse der Stromversorgungseinrichtung) jeweils eine lineare Topologie aufweisen. Diese Ausführungsform kann vorteilhaft zur Verbindung großer Gleisfelder verwendet werden.

Bei einer siebten Ausführungsform sind ein Energiebus mit ringförmiger Topologie und ein Energiebus mit linearer Topologie durch die Buskoppeleinheit miteinander gekoppelt.

Vorzugsweise weist das Verbraucher-Busankoppelelement sowohl an der negativen als auch an der positiven Potentialseite der Busleitung jeweils ein erstes Schaltelement zur elektrischen Trennung der Busleitung und ein zweites Schaltelement zum Zuschalten des Verbrauchers zum Energiebus auf, wobei die ersten Schaltelemente Teil der Busleitung und die zweiten Schaltelemente Teil einer im Verbraucher-Busankoppelelement integrierten, von der Busleitung zum Verbraucher führenden Versorgungsleitung sind.

Die Erfindung betrifft auch ein Verfahren zum Betreiben einer Energieversorgungseinrichtung nach einem der vorhergehenden Ansprüche, wobei das Verfahren folgende Verfahrensschritte umfasst:
a) Auswahl eines zu überprüfenden Bussegments, wobei am Referenz-Busankoppelelement des zu überprüfenden Bussegments eine Betriebsspannung anliegt und wobei die ersten Schaltelemente des Referenz-Busankoppelelements des zu überprüfenden Bussegments geöffnet sind, so dass am Prüf-Busankoppelelement eine gegenüber der Betriebsspannung reduzierte Prüfspannung anliegt;
b) Messung einer ersten Brückenspannung und einer zweiten Brückenspannung der doppelten Wheatstone'schen Brückenschaltung;
c) Prüfen in Abhängigkeit von den gemessenen Brückenspannungen, ob eine Störung vorliegt;
d) Falls keine Störung vorliegt wird das Prüf-Busankoppelelement zum Energiebus zugeschaltet indem die Schaltelemente des ersten Schaltelement-Paars des Referenz-Busankoppelelements geschlossen werden, und die Schritte a) - d) werden wiederholt, wobei ein nachfolgendes Bussegment als das zu überprüfende Bussegment ausgewählt wird;
e) Falls eine Störung vorliegt, wird das Verfahren gestoppt und somit das Prüf-Busankoppelelement nicht zum Energiebus zugeschaltet und keine weiteren Bussegmente überprüft.

Das Verfahren mit den Schritten a) - e) läuft in allen Richtungen abgehend von den Stromversorgungen ab. Das heißt, auf einer Strecke mit Störstelle stoppt das Verfahren auch von der anderen Versorgungsrichtung. Dadurch wird die Störstelle isoliert, wobei trotzdem alle Busankoppelelemente mit Energie versorgt werden.

Das erfindungsgemäße Verfahren ermöglicht die Prüfung einzelner Bussegmente eines Energiebusses auf Störungen (Kurzschlüsse) ohne die Verbraucher des Energiebusses außer Betrieb zu nehmen und ein zeitnahes Zuschalten der überprüften Busankoppelelemente.

Als "nachfolgendes Bussegment" wird ein Bussegment bezeichnet, welches elektrisch auf der der Speisung abgewandten Seite des zuvor überprüften Bussegments angeordnet ist.

Diejenigen Verbraucher-Busankoppelelemente, für die keine Störung für die dem Verbraucher-Busankoppelelement vorgeschalteten Bussegmente ermittelt wurde, werden erfindungsgemäß nacheinander zugeschaltet. Falls die Prüfung des Bussegments negativ ausfällt (also eine Störung festgestellt wird), wird das entsprechende Prüf-Busankoppelelement (dem Bussegment nachgeschaltetes Verbraucher-Busankoppelelement) nicht zugeschaltet. Der Energiebus kann dann jedoch in dem Umfang, in dem bis dahin die Verbraucher-Busankoppelelemente zugeschaltet wurden, betrieben werden.

Das Anlegen der Betriebsspannung erfolgt durch die Speisung. Während der erfindungsgemäßen Prüfung sind die Schaltelemente des ersten Schaltelemente-Paars des jeweiligen Prüf-Busankoppelelements geöffnet, so dass der Prüfbrückenzweig bestromt wird. Das Prüf-Busankoppelelement befindet sich dann im Grundzustand, d.h. das Prüf-Busankoppelelement trennt die Busleitung elektrisch und an das Prüf-Busankoppelelement anzuschließende Verbraucher sind vom Prüf-Busankoppelelement elektrisch getrennt. Auf diese Weise kann das Prüf-Busankoppelelement zur Prüfung des vorangehenden Bussegments verwendet werden, ohne dass ein an dem Prüf-Busankoppelelement angeschlossener Verbraucher angeschaltet wird (aufgrund der gegenüber der Betriebsspannung reduzierten anliegenden Prüfspannung). Die Prüfspannung beträgt vorzugsweise 1/3 der Betriebsspannung. Die Widerstände der Brückenschaltung sind so gewählt, dass die Prüfspannung stets kleiner ist als die minimale Betriebsspannung des Verbraucher-Busankoppelelements ist.

Bei der erfindungsgemäßen Störungsprüfung ist der Energiebus elektrisch weitgehend entkoppelt, so dass nur ein Teil der Busankoppelelemente, nämlich von der Speisung ausgehend bis zum Referenz-Busankoppelelement, durch die Speisung mit Energie versorgt wird.

Eine Störung wird vorzugsweise dann festgestellt, wenn
i) die erste Brückenspannung und die zweite Brückenspannung einen positiven Grenzwert überschreiten, oder
ii) die erste Brückenspannung und die zweite Brückenspannung einen negativen Grenzwert unterschreiten, oder
iii) wenn die erste Brückenspannung einen negativen Grenzwert unterschreitet und die zweite Brückenspannung einen positiven Grenzwert überschreitet.

Als "erste Brückenspannung" wird die Spannung zwischen Referenzpunkt und Prüfpunkt des Indikatorbrückenzweigs auf der positiven Potentialseite bezeichnet.

Als "zweite Brückenspannung" wird die Spannung zwischen Referenzpunkt und Prüfpunkt des Indikatorbrückenzweigs auf der negativen Potentialseite bezeichnet.

Im Fall von i) liegt ein Kurzschluss gegen Erde auf der negativen Potentialseite des Energiebusses vor. Im Fall von ii) liegt ein Kurzschluss gegen Erde auf der positiven Potentialseite des Energiebusses vor. Im Fall von iii) liegt ein Leitungskurzschluss zwischen der negativen und der positiven Potentialseite des Energiebusses vor.

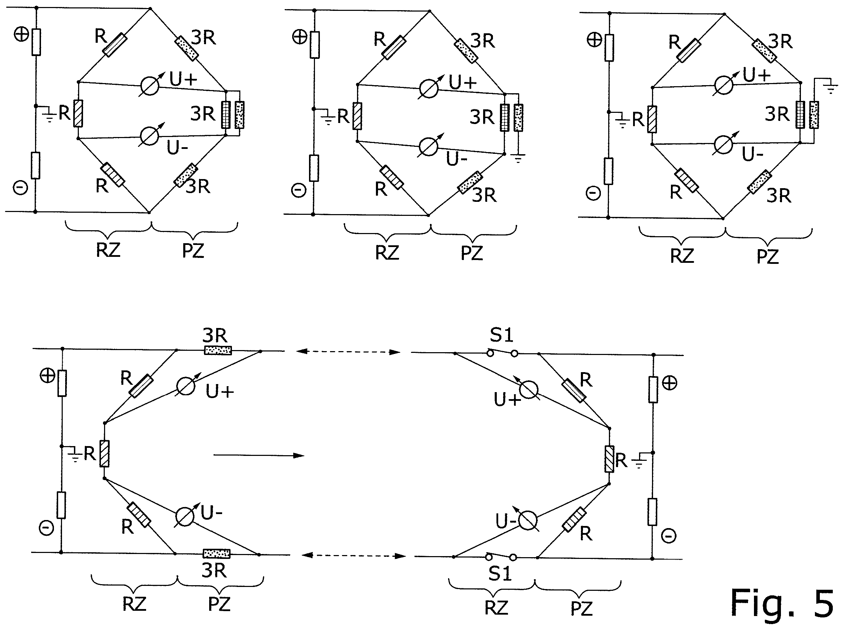

Wenn die erste Brückenspannung einen positiven Grenzwert überschreitet und die zweite Brückenspannung einen negativen Grenzwert unterschreitet, liegt entweder eine offene Leitung oder ein Zusammenschluss der Busleitungen vor (Systembedingt kann nicht zwischen einer offenen Leitung und dem Zusammenschluss unterschieden werden). Der Zusammenschluss ist die letzte Messung, wenn das gleiche Bussegment von beiden Seiten gleichzeitig geprüft wird (falls der Energiebus von zwei Seiten aufgebaut wird). Bei einer offenen Leitung oder einem Zusammenschluss handelt es sich nicht um eine Störung. Ein solcher Zustand kann zwar erfasst werden, soll aber nicht das Schließen der Schaltelemente des ersten Schaltelement-Paares verhindern (s. Fig. 5, unten rechts). Mit dem Schließen der Schaltelemente des ersten Schaltelement-Paares von beiden Seiten her wird der Energiebus durchverbunden.

Bei einer ersten Variante wird das erfindungsgemäße Verfahren zum Hochfahren des Energiebusses (Busaufbau) eingesetzt, wobei das Zuschalten der Busankoppelelemente (Schritt d)) sequentiell ausgehend von der Speisung erfolgt.

Beim Busaufbau sind zuerst alle Verbraucher-Busankoppelelemente im Grundzustand. Damit ist der Bus an allen Segmenten getrennt. Ausgangspunkt ist also ein stromloser Energiebus, bei dem alle ersten Schaltelement-Paare geöffnet sind. Ausgehend von der Speisung werden die Bussegmente nacheinander auf Störungen geprüft und das entsprechende Prüf-Busankoppelelement und somit auch das zugehörige (dem Prüfankoppelelement vorangehende) Bussegment wird (falls keine Störung festgestellt wird) zum Energiebus zugeschaltet.

Das erfindungsgemäße Verfahren verhindert, dass ein kurzschlussbehaftetes Bussegment zugeschaltet wird und damit der ganze Energiebus zusammenbricht. Es wird also sichergestellt, dass beim Aufbau des Energiebusses nur intakte Bussegmente zugeschaltet werden.

Diese Messung ist qualitativ und genügt gegebenenfalls nicht den normativen Vorgaben für die IT-Netzform (DIN N 61557-8). Um das erfindungsgemäße Verfahren bei IT-Netzform in der Leit- und Sicherungstechnik zu verwenden, wird daher zusätzlich ein oder mehrere Isolationsüberwachungsgeräte verwendet, welche unabhängig von der erfindungsgemäßen Störungsprüfung den mit einem Kurzschluss einhergehenden Potentialverschiebungen und/oder Ableitströme quantitativ erfasst. Die Ausgabe ist ein Isolationswiderstand des Energiebusses gegenüber Erdpotential.

Durch das erfindungsgemäße Verfahren können beim Busaufbau Bussegmente mit Kurzschlüssen zwischen den Busleitungen und Kurzschlüsse gegen Erdpotential ermittelt werden.

Alternativ oder zusätzlich kann das Verfahren während des Betriebs des Energiebusses eingesetzt werden nachdem eine Störung im Betrieb, insbesondere ein Kurzschluss, und eine Isolierung des von der Störung im Betrieb betroffenen Bussegments im Energiebus festgestellt wurde.

Vorzugsweise wird die Störung im Betrieb durch Detektion einer Unterspannung an einem oder mehreren Verbraucher-Busankoppelelementen detektiert. Bei den Verbraucher-Busankoppelelementen, bei denen die Unterspannung detektiert wurde, wird dann durch Öffnen der zweiten Schaltelemente der Verbraucher vom Energiebus automatisch getrennt. Die Isolierung des von der Störung im Betrieb betroffenen Bussegments erfolgt durch Öffnen der ersten Schaltelemente automatisch.

Wenn während des Betriebs des Energiebusses eine Überlast durch Kurzschluss zwischen Busleitungen auftritt, wird in der Speisung durch die Strombegrenzung der Spannungsversorgungen die Spannung reduziert und/oder es entsteht durch die hohen Ströme auf langen Leitungen ein großer Spannungsabfall. Am Verbraucher-Busankoppelelement entsteht eine Unterspannung. Das Verbraucher-Busankoppelelement reagiert sofort selbständig lokal und öffnet die ersten Schaltelemente. Damit wird der Bus an einem oder meist an mehreren Orten unterbrochen (zerteilt in mehrere spannungslose Bussegmente). Ausgehend von diesem Schaltungszustand wird das erfindungsgemäße Verfahren durchgeführt, so dass die Bussegmente, bei denen keine Störung festgestellt wird, sequentiell wieder zugeschaltet werden können.

Ausgehend vom letzten noch geschlossenen ersten Schaltelemente-Paar (also vom letzten noch bestromten Bussegment) beginnt (vorzugsweise beidseitig) wieder das sequentielle Zuschalten der Bussegmente (Busaufbau). Das Zuschalten wird vor der Kurzschlussstelle gestoppt, so dass das gestörte Bussegment nicht zugeschaltet wird. Das Prüfen und Zuschalten erfolgt vorzugsweise beidseitig. Auf diese Weise wird die Kurzschlussstelle isoliert und der Ort des Kurzschlusses ist lokalisiert.

Im Falle einer beidseitigen Einspeisung können (trotz Unterbrechung des Energiebusses am gestörten Bussegment) im nachfolgenden Betrieb alle Verbraucher-Busankoppelelemente mit Energie versorgt werden - die Verbraucher-Busankoppelelemente links von dem gestörten Bussegment von links - die anderen Verbraucher-Busankoppelelemente von rechts. Vorzugsweise versorgen lokalen Energiespeicher die Verbraucher während der Phase des erneuten Busaufbaus

Vorzugsweise wird in Schritt d) ein Bussegment als zu überprüfendes Bussegment (nachfolgendes Bussegment) ausgewählt, das benachbart zum zuvor ausgewählten zu überprüfenden Bussegment ist. Auf diese Weise wird der Energiebus lückenlos geprüft.

Bei dem erfindungsgemäßen Verfahren wird der Bezug zum Erdpotential hochohmig an der Einspeisestelle hergestellt. Bei ausgedehnten Bussystemen kann es jedoch vorteilhaft sein, wenn während der Messung mit der Brückenschaltung lokal beim Zentrumswiderstand temporär ein Bezug zum Erdpotential hergestellt wird.

Bei einer bevorzugten Variante wird daher im Referenzbrückenzweig (nicht jedoch im Prüfbrückenzweig) temporär ein lokales Bezugspotential zur Erde geschaltet, vorzugsweise indem der mittlere Brückenwiderstand in zwei Brückenwiderstandselemente aufgeteilt und zwischen diesen Brückenwiderstandselementen ein weiteres Schaltelement gegen Erdpotential geschaltet ist. Dadurch kann die Messgenauigkeit erhöht werden. Dieses weitere Schaltelement wird nur im Prüfbrückenzweig während der Messung geschlossen.

Vorzugsweise wird der Energiebus beidseitig mit Energie gespeist. Dadurch wird es einerseits ermöglicht, den Energiebus von beiden Seiten aufzubauen.

Bei einer speziellen Weiterbildung dieser Variante werden die Schritte a) - e) gleichzeitig für ein weiteres zu überprüfendes Bussegment durchgeführt werden, wobei die Prüfspannung an das zu überprüfende Bussegmente und an das weitere zu überprüfende Bussegment von verschiedene Richtungen innerhalb des Energiebusses angelegt wird. Auf diese Weise können mehrere Bussegmente gleichzeitig überprüft werden. "Richtung", aus der die Bussegmente mit Spannung versorgt werden bezieht sich auf Richtung innerhalb des Energiebusses. Die zu überprüfenden Bussegmente werden also von verschiedenen Seiten des Energiebusses mit Energie versorgt.

Zur beidseitigen Einspeisung kann ein Energiebus mit einer ringförmigen Topologie und einer einzigen Speisung verwendet werden. Alternativ hierzu kann die Versorgung des Weiteren zu überprüfenden Bussegments mit der Prüfspannung mittels einer zweiten Speisung erfolgen. In diesem Fall wird ein Energiebus mit einer linearen Topologie verwendet. Vorzugsweise werden mehr als zwei Speisungen verwendet. Durch Steuerung der Spannung der Speisungen kann somit im widerstandsbelasteten Bus eine Balancierung der Energieeinspeisung durchgeführt werden.

Bei einer besonders bevorzugten Variante werden während des Betriebs des Energiebusses Isolationsmessungen mittels eines Isolationsüberwachungsgeräts an Leitungsabschnitten der Busleitung durchgeführt, die mittels einer Diagnoseeinheit ferngesteuert werden, wobei Verbraucher innerhalb dieses Leitungsabschnitts in Betrieb bleiben. Die Isolationsmessungen dienen zur Erfüllung von normativen Vorgaben hinsichtlich der Überwachung der Netzform IT (isolée terre).

Das erfindungsgemäß Verfahren kann besonders vorteilhaft in der Bahntechnik verwendet werden.

Die Verbraucher-Busankoppelelemente werden sequentiell vom Grundzustand in den zweiten Betriebszustand gebracht, so dass die Verbraucher-Busankoppelelemente sequentiell durch Versorgung mit Energie der Speisung angeschaltet werden.

Die Speisungen speisen mittels jeweils eines Einspeise-Busankoppelelements Strom in den Energiebus. Innerhalb eines Energiebusses können beliebig viele Speisungen vorgesehen sein. Die Anzahl der Einspeise-Busankoppelelemente richtet sich nach der Anzahl der Speisungen.

Vorzugsweise umfassen die Einspeise-Busankoppelelemente eine Reihe von Schaltelementen und Dioden. Die Schaltelemente trennen den Bus an den Segmentgrenzen und erlauben eine kontrollierte, unabhängige Einspeisung des Stroms in die angrenzenden Busleitungen. Die Dioden bzw. gesteuerten Schalter entkoppeln die Speisung (Speisungen) bei Rückwärtsenergieeintrag (z.B. durch die Verwendung weiterer Speisungen bei kurzen Leitungen und unterschiedlichen Spannungen).

Vorzugsweise werden im Falle eines defekten Segments der Busleitung (z.B. bei Unterbrechung oder Kurzschluss), die an dem defekten Segment angrenzenden Verbraucher-Busankoppelelemente in den ersten Betriebszustand versetzt. Die Busleitung wird also dann an der defekten Stelle unterbrochen. Aufgrund der beidseitigen Einspeisung können trotzdem alle Verbraucher mit Strom versorgt werden. Bei Kurzschluss in einem Bussegment wird das betroffene Bussegment also durch die benachbarten Verbraucher-Busankoppelelemente isoliert.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt eine Energieversorgungseinrichtung mit einem gestörten Bussegment.
- Fig. 2: zeigt ein erfindungsgemäßes Verbraucher-Busankoppelelement.
- Fig. 3: zeigt einen Ausschnitt einer ersten Ausführungsform einer erfindungsgemäßen Energieversorgungseinrichtung sowie die enthaltene doppelte Brückenschaltung zur Bussegment-Prüfung.
- Fig. 4: zeigt mögliche Störungen eines Bussegments innerhalb einer erfindungsgemäßen Energieversorgungseinrichtung.
- Fig. 5: zeigt die Verschiebung der Spannungspotentiale durch Störströme für verschiedene Leitungsstörungen.
- Fig. 6: zeigt einen Ausschnitt einer weiteren Ausführungsform einer erfindungsgemäßen Energieversorgungseinrichtung mit temporärem Bezugspotential sowie die enthaltene Doppel-Brückenschaltung zur BussegmentPrüfung.
- Fig. 7: zeigt einen Ausschnitt einer erfindungsgemäßen Energieversorgungseinrichtung, mit einem Einspeise-Busankoppelelement, das als ReferenzBusankoppelelement dienen kann.
- Fig. 8: zeigt ein Einspeise-Busankoppelelement, welches beidseitig als ReferenzBusankoppelelement dienen kann.

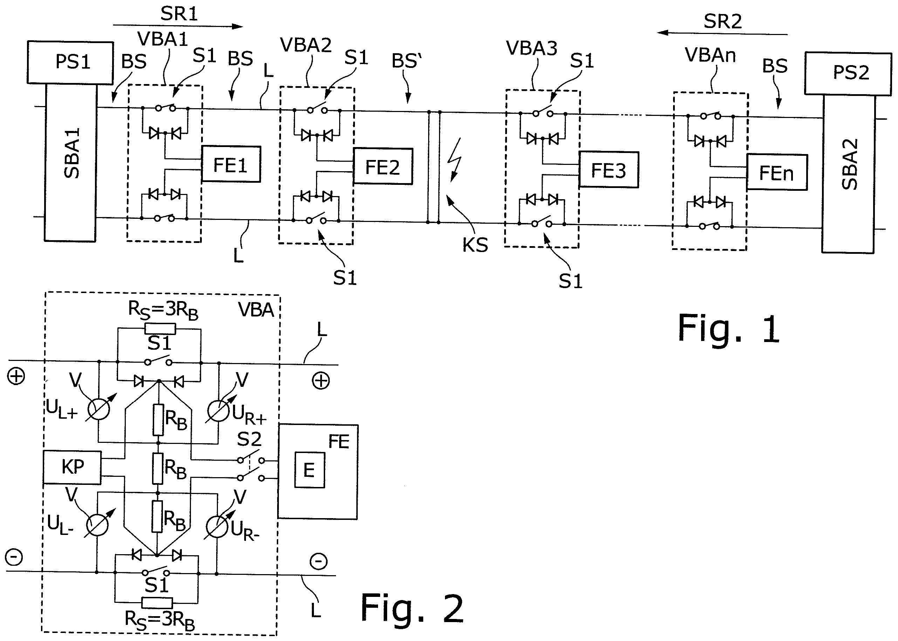

**Fig. 1** zeigt eine Energieversorgungseinrichtung mit einer zweipoligen Busleitung **L**, die durch Busankoppelelemente (Verbraucher-Busankoppelelemente **VBA1,** ..., **VBAn** und Einspeise-Busankoppelelemente **SBA1, SBA2**), in Bussegmente BS unterteilt ist. Über Schaltelemente **S1** kann die Busleitung L unterbrochen (in Bussegmente **BS** segmentiert) werden. Der Energiebus weist hier beispielhaft eine lineare Topologie auf und wird von beiden Seiten des Energiebusses durch jeweils eine Speisung **PS1, PS2** mit Energie versorgt. Das Hochfahren des Energiebusses erfolgt dann vorzugsweise ausgehend von den beiden Speisungen PS1, PS2 in Sequenzrichtungen SR1, SR2 gleichzeitig von beiden Seiten des Energiebusses sequentiell gemäß dem unten beschriebenen erfindungsgemäßen Verfahren. Dazu ist das erste Verbraucher-Busankoppelelement VBA1 über das Einspeise-Busankoppelelement SBA1 an der ersten Speisung PS1 und das n-te (letzte) Verbraucher-Busankoppelelement VBAn über ein weiteres Einspeise-Busankoppelelement SBA2 an der weiteren Speisung PS2 direkt angeschlossen. Im Fall einer Störung (Kurzschluss KS) eines der Bussegmente BS', kann das betreffende Bussegment BS' isoliert werden, indem die benachbarten Verbraucher-Busankoppelelemente (hier: Verbraucher-Busankoppelelemente VBA2, VBA3) durch Öffnen der Schaltelemente **S1** in den ersten Betriebszustand (s.u.) gebracht werden. Verbraucher **FE1, FE2**, die an den Verbraucher- Busankoppelelementen VBA1, VBA2, welche links des gestörten Bussegments BS' angeordnet sind, können dann über die erste Speisung PS1, die Verbraucher **FE3 ... FEn**, welche rechts des gestörten Bussegments BS' angeordnet sind, über die weitere Speisung PS2 versorgt werden.

Aus Konstruktionsgründen besitzen Schaltnetzteile zum Teil recht hohe Eingangskapazitäten, welche große Einschaltströme (rush-in currents) verursachen. Die Stromtransienten führen wiederum auf dem Energiebus zu Spannungseinbrüchen. Durch die Sequenzierung können Einschaltstromspitzen beim simultanen Anschalten eines ganzen Netzwerkes von Nutzlasten (Verbrauchern) vermieden werden.

Gemäß dem erfindungsgemäßen Verfahren werden die Verbraucher und die Bussegmente während des Busaufbau sequentiell auf Störungen überprüft und dem Energiebus zugeschaltet.

Ein Verbraucher-Busankoppelelemente **VBA**, welches die Durchführung des erfindungsgemäßen Verfahrens und damit die Isolation eines gestörten Bussegments und den (Neu)Aufbau des Energiebusses mit isoliertem Bussegment ermöglicht, ist in **Fig. 2** gezeigt. Das Verbraucher-Busankoppelelement VBA umfasst neben dem erstes Schaltelemente-Paar mit den ersten Schaltelementen **S1**, ein zweites Schaltelemente-Paar mit zweiten Schaltelementen **S2**, Dioden und einen Kontrollprozessor **KP**. Die Dioden dienen der Anschaltung des Kontrollprozessors KP und eines Verbrauchers **FE** an die Busleitung L. Der Kontrollprozessor KP ist parallel zum Prüfbrückenzweig PZ geschaltet und wird ein- oder zweiseitig von der Busleitung L über die Dioden gespeist. Er schaltet den Verbraucher FE nach einem bestimmten vorgegebenen Kriterium zu. Das in Fig. 2 gezeigte Verbraucher-Busankoppelelement VBA befindet sich im Grundzustand (Schaltelemente S1, S2 sind geöffnet). Mittels der zweiten Schaltelemente S2 kann der Verbraucher FE zugeschaltet werden (erster Betriebszustand). Durch Schließen der ersten Schaltelemente S1 wird die Busleitung L (vorzugsweise nach einer zeitlichen Verzögerung nach Schließen der zweiten Schaltelemente S2) durchverbunden (zweiter Betriebszustand).

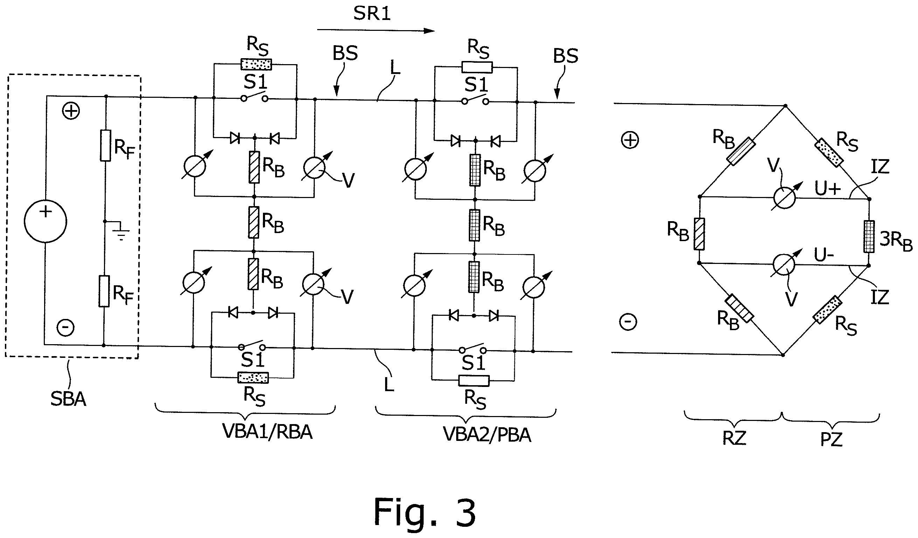

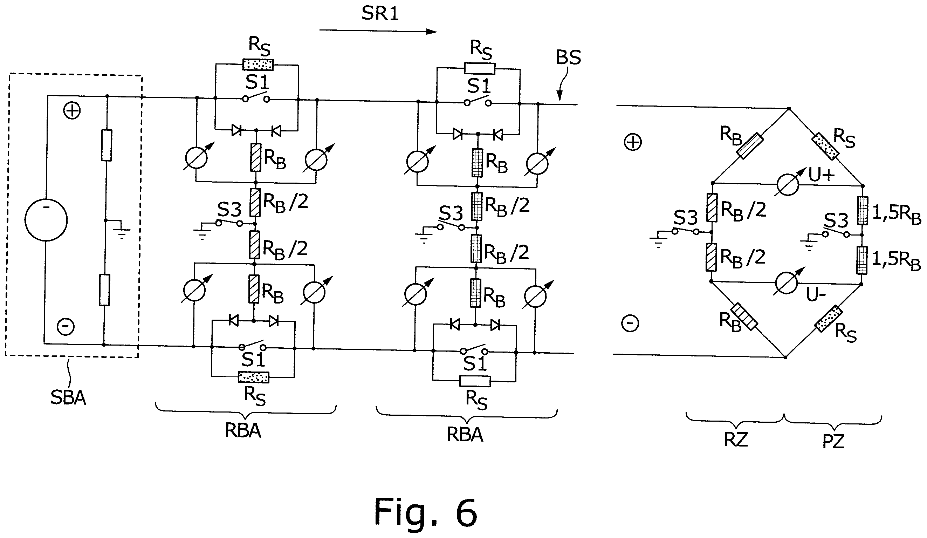

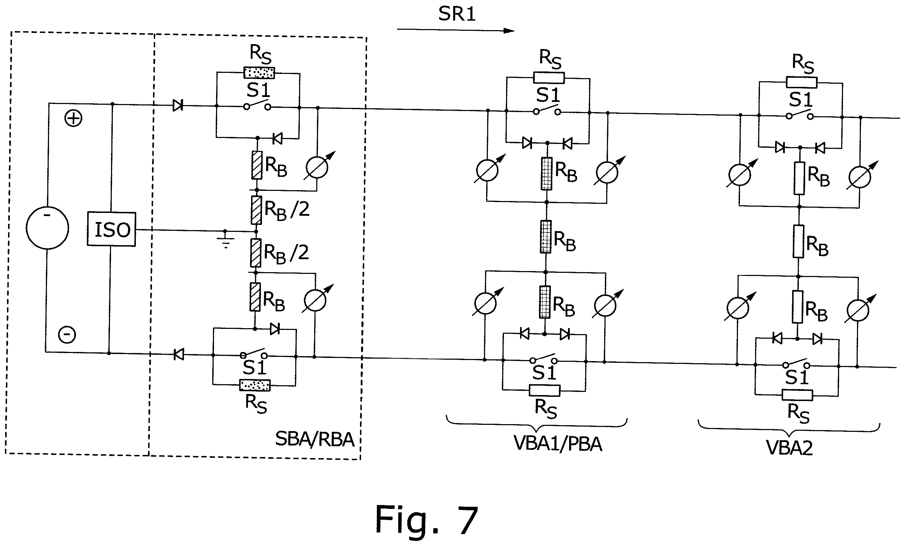

Gemäß dem erfindungsgemäßen Verfahren wird nach dem Zuschalten einer Einspeisespannung z.B. von Speisung PS1 das in Sequenzrichtung SR1 erste Bussegment VBA1 auf Störungen überprüft. Für die Überprüfung eines Bussegments dient das dem Bussegment vorausgehende Busankoppelelement als Referenz-Busankoppelelement. Wird das erste Bussegment überprüft, dient das Einspeise-Busankoppelelement als Referenz-Busankoppelelement RBA (SBA/RBA s. Fig. 7). An dem zu überprüfenden Bussegment BS liegt bei geöffneten ersten Schaltelementen S1 des Referenz-Busankoppelelements RBA eine Prüfspannung an und es wird eine unten näher beschriebene Brückenschaltung (s. Fig. 3, Fig. 6) realisiert. Bedingt durch den Spannungsabfall an den Überbrückungswiderstände ist die Spannung über den Brückenwiderständen (Prüfspannung) und damit am Kontrollprozessor KP während des Prüfvorganges kleiner als die minimale Einspeisespannung. Anhand der mittels der Brückenschaltung gemessenen Brückenspannungen **U+, U- bzw. UR+, U_{R}-; U_{L}+, U_{L}-** (je nach Sequenzrichtung) können eventuell vorhandene Störungen festgestellt werden. Nach erfolgreicher Prüfung (Feststellen, dass im zu überprüfende Bussegment keine Störung vorliegt) wird durch Schließen der ersten Schaltelemente S1 des Referenz-Busankoppelelements RBA das zu überprüfende Bussegment niederohmig mit Energie versorgt. Im Falle der Überprüfung des ersten Bussegments liegt dann am ersten Verbraucher-Busankoppelelement VBA1 eine Betriebsspannung an, die (aufgrund von Spannungsverlusten entlang der Busleitung) i.A. kleiner als die Einspeisespannung ist (typischerweise 500 ... 900 VDC).

Im Kontrollprozessor KP des Verbraucher-Busankoppelelements VBA wird daraufhin das Überschreiten der minimalen Betriebsspannung erkannt und der Verbraucher FE1 wird durch Schließen der zweiten Schaltelemente S2 des ersten Verbraucher-Busankoppelelements VBA1 über einen Sanftanlauf zugeschaltet. Nach Abschluss des Hochfahrens des ersten Verbrauchers FE1 wird die Prüfung des nächsten Bussegmentes durchgeführt. In Sequenzrichtung SR1 wird nun völlig autonom ein Bussegment nach dem anderen überprüft und (falls keine Störung vorliegt) zugeschaltet. Gleichzeitig und unabhängig davon kann dieses Verfahren ausgehend von der zweiten Speisung PS2 in Sequenzrichtung SR2 erfolgen. Wird bei einem Bussegment BS' eine Störung (z.B. Kurzschluss) festgestellt, findet das Zuschalten des entsprechenden Bussegments BS' nicht statt. Bei einem beidseitigen Busaufbau wird dann von jeder Seite ausgehend ein Teilbus (jeweils von der Speisung PS1, PS2 bis zum gestörten Bussegment BS') aufgebaut, so dass das gestörte Bussegment BS' isoliert bleibt. Trotz der Störung in Bussegment BS' können dann der Energiebus und die daran angeschlossenen Verbraucher FE1, ... FEn weiter betrieben werden.

Diese sequentielle Prüfung und Zuschaltung von Bussegmenten kann beim initialen Busaufbau durchgeführt werden oder auch nach Abschaltung von Verbrauchern aufgrund eines Kurzschlusses im Betrieb des Energiebusses, wie im Folgenden beschrieben: Bei einem Kurzschluss zwischen den Leitern fließt zunächst der maximale mögliche Strom der Speisungen PS1, PS2 und die Speisungen PS1, PS2 reduzieren üblicherweise die Spannung, um den Strom zu begrenzen. Im Energiebus werden die Ströme in der Regel aktiv begrenzt und es kommen keine Sicherungen auf der Einspeiseseite der Einspeisespannung zum Einsatz. Das Auftreten eines Kurzschlusses führt damit zu einer erheblichen Spannungsreduktion, was zum Abschalten der angeschlossenen Verbraucher durch Öffnen der zweiten Schaltelemente S2 führt (Detektion Unterspannung durch den Kontrollprozessor KP). Die erfindungsgemäße Energieversorgungseinrichtung verfügt vorzugsweise über lokale Energiespeicher **E** in den Verbrauchern, welche den gesamten Betrieb über einige Minuten aufrechterhalten können. Damit gewinnt man Zeit für den Neuaufbau des Energiebusses ab den letzten abgeschalteten Verbraucher-Busankoppelelementen VBA. Denn sobald eine Unterspannung in einem oder mehreren Verbraucher-Busankoppelelement(en) VBA detektiert wird, wird individuell in jedem Verbraucher-Busankoppelelement, in dem eine Unterspannung detektiert wurde, sofort und grundsätzlich der Kopplungsschalter S1 geöffnet. Die Spannung an den Speisungen PS1, PS2 kehren auf den ursprünglichen Einstellwert (vor der Strombegrenzung) zurück. Der sequenzielle Aufbau beginnt beidseitig ab den letzten abgeschalteten Verbraucher-Busankoppelelementen VBA von neuem, wobei er jeweils vor der Kurzschlussstelle abbricht. Das erfindungsgemäße Verfahren arbeitet vollständig ohne übergeordnete Konfiguration und Steuerung und ermöglicht einen sicheren und schnellen Busaufbau, insbesondere auch während des Betriebs des Energiebusses, ohne dass Verbraucher abgeschaltet werden müssen, so dass auch nach Verlust (Unbrauchbarkeit) eines Bussegmente BS durch Kurzschluss die Funktionalität des Energiebusses gewährleistet werden kann.

Erfindungsgemäß erfolgt beim Hochfahren des Energiebusses oder bei Wiederinbetriebnahme des Energiebusses nach einer Störung das Umschalten in die Betriebszustände nur dann, wenn das dem Verbraucher-Busankoppelelement VBA nachgeschaltete Bussegment auf Störungen geprüft wurde und als störungsfrei eingestuft wurde. Für diese Prüfung sind die Verbraucher-Busankoppelelemente VBA so aufgebaut, dass die Störungs-Prüfung mittels einer doppelten Wheatstone'schen Brückenschaltung durchgeführt werden kann. Dazu umfassen die Verbraucher-Busankoppelelemente VBA drei Brückenwiderstände **R_{B}**, die zwischen positiver Potentialseite und negativer Potentialseite der Busleitung L miteinander in Serie geschaltet sind, und zwei Überbrückungswiderstände **R_{S},** die jeweils ein Schaltelement S1 des ersten Schaltelementpaars überbrücken.

Der Übersichtlichkeit halber sind bei den Darstellungen der Fig. 3-7 Kontrollprozessor und Speisung nicht gezeigt.

**Fig. 3** zeigt links einen Ausschnitt einer ersten Ausführungsform einer erfindungsgemäßen Energieversorgungseinrichtung mit einem Einspeise-Busankoppelelement **SBA** sowie zwei Verbraucher-Busankoppelelementen VBA1, VBA2, die das zu überprüfende Bussegment BS begrenzen. Das dem Einspeise-Busankoppelelement SBA (in Pfeilrichtung, welche die Richtung der Busaufbausequenz darstellt) näher gelegene Verbraucher-Busankoppelelement VBA1 dient bei der erfindungsgemäßen Überprüfung des (hier beispielhaft ausgewählten) zu Bussegments BS als Referenz-Busankoppelelement **RBA**, das dem Einspeise-Busankoppelelement SBA entferntere gelegene Verbraucher-Busankoppelelement dient als Prüf-Busankoppelelement **PBA**. Komponenten der beiden Verbraucher-Busankoppelelemente RBA, PBA und das zu überprüfende Bussegment bilden die für das erfindungsgemäße Verfahren benötigte doppelte Brückenschaltung, welche in Fig. 3 rechts dargestellt ist. Dabei bilden die Brückenwiderstände R_{B} (schraffiert) des Referenz-Busankoppelelements RBA einen Referenzbrückenzweig **RZ** und die Brückenwiderstände R_{B} (kariert) des Prüf-Busankoppelelements PBA zusammen mit den Überbrückungswiderständen R_{S} (gepunktet) des Referenz-Busankoppelelements RBA einen Prüfbrückenzweig **PZ**. Die Brückenwiderstände R_{B} eines bestimmten Verbraucher-Busankoppelelements können, je nachdem ob das dem jeweiligen Verbraucher-Busankoppelelement vorangehende oder nachfolgende Bussegment überprüft werden soll, Teil des Prüfbrückenzweigs PZ oder des Referenzbrückenzweigs RZ der Brückenschaltung sein. So kann bspw. das Verbraucher-Busankoppelelement VBA1 auch als Prüf-Busankoppelelement zur Prüfung des vom Einspeise-Busankoppelelement SBA1 und dem Verbraucher-Busankoppelelement VBA1 begrenzten Bussegments dienen.

Zwischen den äußeren Brückenwiderständen und dem mittleren Brückenwiderstand geht jeweils ein Indikator-Brückenzweig **IZ** zur Busleitung L ab. Jeder Indikatorbrückenzweig IZ umfasst eine Spannungsmesseinrichtung **V**. Bei den in Fig. 2 und Fig. 3 gezeigten Verbraucher-Busankoppelelementen sind jeweils beidseitig (in Richtung entlang der Busleitung L) Indikatorbrückenzweige IZ jeweils zur positiven und zur negativen Potentialseite der Busleitung L gezeigt; dies ermöglicht das Durchführen der erfindungsgemäßen Prüfung aus beiden Sequenzrichtungen SR1, SR2. Es ist jedoch auch möglich, Indikatorzweige zur positiven und zur negativen Potentialseite der Busleitung L nur an einer Seite (und zwar an der der Speisung abgewandten Seite des Busankoppelelements, vorzusehen, insbesondere wenn der Energiebus nur eine einzige Speisung umfasst. Über die Indikatorbrückenzweige IZ werden die Brückenspannungen U+, U-, gemessen. Anhand dieser hochimpedanten, potentialfreien Spannungsmessung können alle relevanten Zustände der Busleitung L erfasst werden.

Die verschiedenen Zustände der Busleitung bzw. des zu überprüfenden Bussegments sind in nachfolgender Tabelle aufgeführt:

| Leitungszustand | Leitung ok | Leitung offen oder Zusammenschluss der Leitung | Leitungskurzschluss | Erdschluss + Pol->Erde | Erdschluss - Pol->Erde |
|---|---|---|---|---|---|
| U+ | ∼0 Volt** | hoch | tief | tief | hoch |
| U- | ∼0 Volt** | tief | hoch | tief | hoch |

| | | | | | |
|---|---|---|---|---|---|
| ** Abweichung von 0 ist abhängig von Einfluss der nachgeschalteten Busankoppelelemente | | | | | |

Das Nichtunterscheiden von "Offener Leitung" und "Zusammenschluss" ist hier nicht kritisch, denn das erfindungsgemäße Verfahren soll eine Störung durch Zuschalten einer "schlechten" Leitung verhindern. Der Leitungszustand "Leitung offen oder Zusammenschluss der Leitung" wird jedoch nicht als Störung gewertet. Wenn also der Zustand "Leitung offen oder Zusammenschluss der Leitung" festgestellt wird, werden die ersten Schaltelemente S1 des Referenz-Busankoppelelements RBA trotzdem geschlossen. Im Falle eines Zusammenschlusses ist der Energiebus dann durchverbunden (komplett aufgebaut). Im Falle einer offenen Leitung bleibt die Sequenzierung automatisch stehen, und der Energiebus kann (beidseitige Einspeisung vorausgesetzt) von der anderen Seite bis zu der gestörten Stelle aufgebaut werden. Das Prüfen, ob alle Verbraucher durch den Energiebus versorgt werden, obliegt der separaten zentralen Diagnoseeinheit.

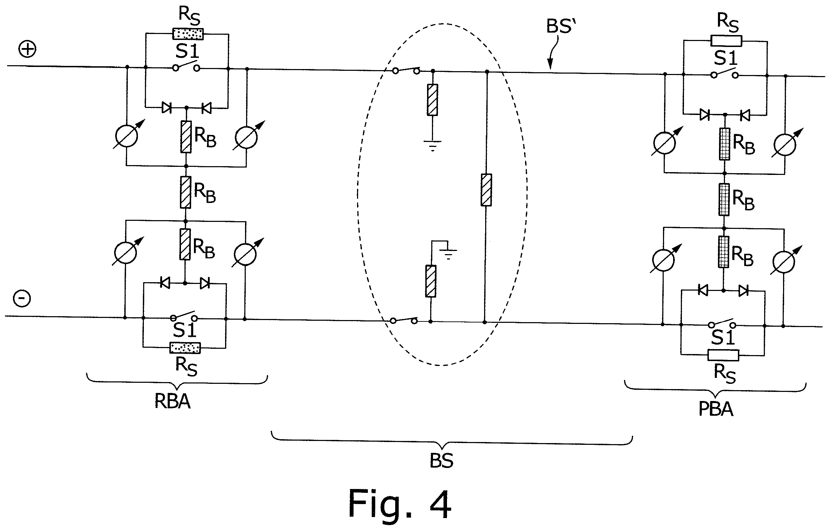

In **Fig. 4** sind im markierten Bereich die entsprechenden Störungen im Energiebus dargestellt (links oben: Erdschluss + Pol->Erde; links unten: Erdschluss - Pol->Erde; rechts Kurzschluss zwischen Busleitungen). Die Verschiebung der Spannungspotentiale (Verzug der Messbrücke) durch Störstrome, welche bei den oben genannte Störungen auftreten, ist in **Fig. 5** dargestellt (oben links: Kurzschluss; oben Mitte: Erdschluss mit + Pol->Erde; oben rechts: Erdschluss mit - Pol->Erde; unten links: Leitung offen; unten links und rechts: Zusammenschluss, wenn mit den gestrichelten Pfeile durchverbunden), wobei die Höhe des Spannungspotentials auf der Vertikalachse aufgetragen ist. In Fig. 5 wurden für die Werte der Brückenwiderstände R_{B} jeweils R und für die Werte der Überbrückungswiderstände R_{S} jeweils 3R angenommen.

Bei den bisher gezeigten Ausführungsformen dient als Bezugspotential eine Erdung im Einspeise-Busankoppelelement SBA. Bei ausgedehnten Bussystemen wird das Bezugspotential zur Erde über die Distanz jedoch ungenau. **Fig. 6** zeigt daher einen Ausschnitt einer weiteren Ausführungsform einer erfindungsgemäßen Energieversorgungseinrichtung mit einem temporären Bezugspotential im Referenzbrückenzweig RZ. Dies wird mit der Teilung des mittleren Brückenwiderstands und dem Vorsehen eines weiteren Schaltelements **S3** erreicht, mit welchem eine Erdverbindung vom Teilungspunkt des mittleren Brückenwiderstands hergestellt werden kann. Wird ein Verbraucher-Busankoppelelement als Referenz-Busankoppelelement verwendet RBA, wird das weitere Schaltelement S3 geschlossen und somit das temporäre Bezugspotential generiert. Wegen der Vorschriften zur Isolationsüberwachung und den geforderten hohen Isolationswerten sollte diese Verbindung während des Betriebes jedoch nicht dauernd bestehen, so dass das weitere Schaltelement S3 geöffnet wird, sobald das entsprechende Verbraucher-Busankoppelelement nicht mehr als Referenz-Busankoppelelement RBA verwendet wird.

In **Fig. 7** ist ein Ausschnitt der erfindungsgemäßen Energieversorgungseinrichtung gezeigt (Kontrollprozessor und Speisung wurden der Übersichtlichkeit halber bei der Darstellung weggelassen), bei der der Aufbau des für die erfindungsgemäße Energieversorgungseinrichtung verwendeten Einspeise-Busankoppelelements SBA dargestellt ist. Mit dem gezeigten Aufbau kann das Einspeise-Busankoppelelement SBA als Referenz-Busankoppelelement RBA zur Überprüfung des (in Pfeilrichtung) ersten Bussegments VBA1 dienen.

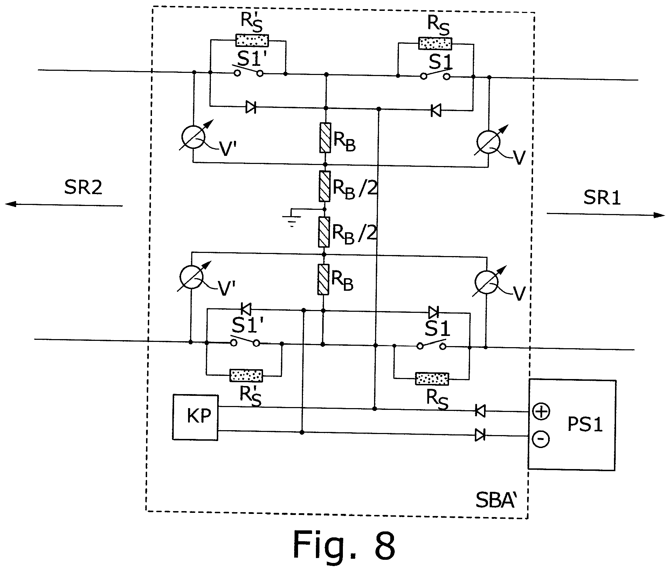

Wird das Einspeise-Busankoppelelement SBA für eine beidseitige Einspeisung (ringförmige Topologie) verwendet, kann auch die Überprüfung der Bussegmente beidseitig (in beide Sequenzrichtungen SR1, SR2) erfolgen. Hierfür muss das Einspeise-Busankoppelelement SBA' gegenüber der in Fig. 7 gezeigten Ausführungsform um weitere erste Schaltelemente **S1'**, welche unabhängig von den ersten Schaltelementen S1 sind, Überbrückungswiderstände **R'_{S}** und Spannungsmesseinrichtungen **V'** erweitert werden, wie in **Fig. 8** gezeigt. Bei dem in Fig. 8 dargestellten Einspeise-Busankoppelelement SBA' ist darüber hinaus der mittlere Brückenwiderstand R_{B} geteilt und kann gleichzeitig für die Balancierung der Spannung im IT Netz genutzt werden.

Bei Kurzschluss gegen Erdpotential während des Betriebs des Energiebusses gibt es bei IT Systemen keine Störung und das Verbraucher-Busankoppelelement erkennt das Problem nicht einmal. Es entsteht im Prinzip kein unmittelbarer Handlungsbedarf. Um diese Störung trotzdem zu detektieren bevor eine weitere Störung auftritt, kann zusätzlich zur oben beschriebenen sequentiellen Überprüfung der einzelnen Bussegmente mittels der Brückenschaltung, eine Isolationsmessung (die bspw. für die IT-Netzform der Leit- und Sicherungstechnik normativ vorgeschrieben ist) durchgeführt werden. Diese Isolationsmessungen werden an der Einspeisestelle mit zertifizierten, industriellen Isolationsüberwachungsgeräten durchgeführt. Das Durchführen der Isolationsüberwachung über einen Versorgungssektor (zwischen zwei Einspeisestellen) erfolgt mit Hilfe einer übergeordneten Diagnoseeinheit, die dafür zuständig ist, die Busleitung an geeigneten Stellen zu trennen, um die Isolationsmessungen durchzuführen. Betrieblich muss sichergestellt sein, dass in einem durchverbundenen Versorgungssektor nur ein Isolationsüberwachungsgerät aktiv zugeschaltet ist. Speziell bei Pulsverfahren (z.B. Bender AMP_{Plus®}) würden sich die Messpulse gegenseitig stören. Moderne Geräte können ein ganzes, ausgedehntes Netz mit einer Kapazität bis 1000 µF in Bezug auf Isolationsfehler prüfen. Für große Netze kann dies bis einige Minuten in Anspruch nehmen. Wenn der Versorgungssektor beidseitig redundant gespeist ist kann im laufenden Betrieb jedes Bussegment einzeln zwischen den Verbraucher-Busankoppelelementen VBA elektrisch isoliert werden.

Die Diagnoseeinheit führt in regelmäßigen Abständen die normativ vorgeschriebene quantitative Isolationsmessung durch. Die Diagnoseeinheit schaltet dazu dem voll betriebsfähigen und beidseitig gespeisten Versorgungssektor eine Trennstelle beginnend vom Ort des aktiven Isolationsüberwachungsgerätes. Nach jeder Messung wird die Trennstelle um ein weiteres Bussegment weitergeschaltet. Durch das Fortschalten der Trennstelle des Energiebusses kann der Erdschluss lokalisiert werden. Mit diesem Verfahren erhält man eine Übersicht über die Isolationsverhältnisse über den gesamten Versorgungssektor mit einer örtlichen Auflösung eines Segmentes..

Die Diagnoseeinheit ruft regelmäßig Betriebsdaten von den Betriebs-Prozessoren der Verbraucher-Busankoppelelemente ab. Dadurch wird Erreichbarkeit der Verbraucher-Busankoppelelemente geprüft und ein Stopp des autonomen sequentiellen Zuschaltens infolge eines Fehlers im neu anzuschaltenden Segment wird erkannt.

Mit der erfindungsgemäßen Vorrichtung und dem erfindungsgemäßen Verfahren ist es möglich, einzelne Bussegmente in Bezug auf Erdschlüsse und Kurzschlüsse zu prüfen und gegebenenfalls zu verhindern, dass diese zum Energiebus zugeschaltet werden. Somit kann verhindert werden, dass durch einen Kurzschluss die Versorgungsspannung im gesamten Energiebus zusammenbricht.

### Bezugszeichenliste

- VBA, VBA1, ... VBAn: Verbraucher-Busankoppelelement
- SBA, SBA1,SBA2: Einspeise-Busankoppelelement
- PS1, PS2: Speisungen
- SR1, SR2: Sequenzrichtungen
- S1, S1': erstes Schaltelement zur Trennung der Busleitungen
- S2: zweites Schaltelement zur Trennung der Verbraucher vom Energiebus
- S3: weiteres Schaltelement gegen Erdpotential zur Erzeugung eines lokalen Bezugspotentials
- FE: Verbraucher/ Feldelemente
- BS: Bussegment
- BS': Bussegment mit Störung
- RZ: Referenzbrückenzweig
- PZ: Prüfbrückenzweig
- IZ: Indikatorbrückenzweig
- V: Spannungsmesseinrichtung im Indikatorbrückenzweig
- R_{S}: Überbrückungswiderstand
- R_{B}: Brückenwiderstände des Referenzbrückenzweigs
- E: lokaler Energiespeicher
- KP: Kontrollprozessor
- ISO: Isolationsüberwachungsgerät

## Patentansprüche

1. Energieversorgungsvorrichtung zur Versorgung von Verbrauchern mit Energie, umfassend
• einen Energiebus mit einer eine 2-poligen Busleitung (L),
• Busankoppelelemente (SBA, SBA1, SBA2, VBA, VBA1, ..., VBAn), wobei zwei Busankoppelelemente ein zu überprüfendes Bussegment der Busleitung (L) begrenzen, und wobei die Busankoppelelemente (SBA, SBA1, SBA2, VBA, VBA1, ..., VBAn) jeweils ein erstes Schaltelemente-Paar mit ersten Schaltelementen (S1) zur elektrischen Trennung der Busleitung (L) umfassen, und
• eine erste Speisung (PS1), insbesondere eine Gleichspannungsquelle,
**dadurch gekennzeichnet,**
**dass** die Busankoppelelemente (SBA, SBA1, SBA2, VBA, VBA1, ..., VBAn) jeweils drei Brückenwiderstände (R_{B}), die zwischen positiver Potentialseite und negativer Potentialseite der Busleitung (L) miteinander in Serie geschaltet sind, und zwei Überbrückungswiderstände (Rs), die jeweils ein Schaltelement (S1) des ersten Schaltelementpaares überbrücken, umfassen,
**dass** die Energieversorgungsvorrichtung zum Ermitteln von Leitungsstörungen eine doppelte Wheatstone'sche Brückenschaltung mit einem Referenzbrückenzweig (RZ), einem Prüfbrückenzweig (PZ) und zwei Indikatorbrückenzweige (IZ), aufweist,
**dass** zur Überprüfung des Bussegments (BS) eines der das zu überprüfende Bussegment begrenzenden Busankoppelelemente (SBA, SBA1, SBA2, VBA, VBA1, ..., VBAn) als Referenz-Busankoppelelement (RBA) und das andere als Prüf-Busankoppelelement (PBA) dient, wobei der Referenzbrückenzweig (RZ) die drei Brückenwiderstände (R_{B}) des Referenz-Busankoppelelements (RBA) umfasst, und wobei der Prüfbrückenzweig (PZ) die drei Brückenwiderstände (R_{B}) des Prüf-Busankoppelelements (PZ) sowie die Überbrückungswiderstände (Rs) des Referenz-Busankoppelelements (PBA) umfasst.

2. Vorrichtung nach Anspruch 1, **dadurch gekennzeichnet, dass** die Verbraucher (FE) zumindest teilweise mit einem lokalen Energiespeicher (E) ausgestattet sind.

3. Vorrichtung nach einem der vorhergehenden Ansprüche, **dadurch gekennzeichnet, dass** die Busleitung (L) mit einer weiteren Speisung (PS2) elektrisch verbunden ist.

4. Vorrichtung nach einem der vorhergehenden Ansprüche, **dadurch gekennzeichnet, dass** der mittlere Brückenwiderstand der in Serie geschalteten Brückenwiderstände (R_{B}) einen höheren Widerstandswert aufweist als die beiden äußeren Brückenwiderstände, insbesondere um einen Faktor 1,2 bis 1,5

5. Vorrichtung nach einem der vorhergehenden Ansprüche, **dadurch gekennzeichnet, dass** ein Isolationsüberwachungsgerät zur Durchführung von Isolationsmessungen an Bussegmenten (BS) und/oder an den einzelnen Busankoppelelementen (VBA, VBA1, ..., VBAn) und eine Diagnoseeinheit zur Steuerung der Isolationsmessungen vorhanden sind.

6. Vorrichtung nach einem der vorhergehenden Ansprüche, **dadurch gekennzeichnet, dass** mindestens ein Verbraucher (FE) an einem der Busankoppelelemente (VBA, VBA1, ..., VBAn) angeschlossen ist, wobei es sich bei den Verbrauchern (FE) vorzugsweise um Komponenten der Leit- und Sicherungstechnik, insbesondere um Feldelemente handelt, wobei die Verbraucher (FE) jeweils eine Logik oder einen Betriebs-Prozessor umfassen.

7. Verfahren zum Betreiben einer Energieversorgungseinrichtung nach einem der vorhergehenden Ansprüche, wobei das Verfahren folgende Verfahrensschritte umfasst:
a) Auswahl eines zu überprüfenden Bussegments, wobei am Referenz-Busankoppelelement (RBA) des zu überprüfenden Bussegments eine Betriebsspannung anliegt und wobei die ersten Schaltelemente (S1) des Referenz-Busankoppelelements (RBA) des zu überprüfenden Bussegments geöffnet sind, so dass am Prüf-Busankoppelelement (PBA) eine gegenüber der Betriebsspannung reduzierte Prüfspannung anliegt;
b) Messung einer ersten Brückenspannung und einer zweiten Brückenspannung der doppelten Wheatstone'schen Brückenschaltung;
c) Prüfen in Abhängigkeit von den gemessenen Brückenspannungen, ob eine Störung vorliegt;
d) Falls keine Störung vorliegt:
wird das Prüf-Busankoppelelement (PBA) zum Energiebus zugeschaltet, indem die Schaltelemente (S1) des ersten Schaltelement-Paars des Referenz-Busankoppelelements (RBA) geschlossen werden, und
die Schritte a) - d) werden wiederholt, wobei ein nachfolgendes Bussegment (BS) als das zu überprüfende Bussegment ausgewählt wird;
e) Falls eine Störung vorliegt, wird das Verfahren gestoppt und somit das Prüf-Busankoppelelement (PBA) nicht zum Energiebus zugeschaltet und keine weiteren Bussegmente (BS) überprüft.

8. Verfahren nach Anspruch 7, **dadurch gekennzeichnet, dass** in Schritt c) eine Störung festgestellt wird, wenn
i. die erste Brückenspannung und die zweite Brückenspannung einen positiven Grenzwert überschreiten, oder
ii. die erste Brückenspannung und die zweite Brückenspannung einen negativen Grenzwert unterschreiten, oder
iii. wenn die erste Brückenspannung einen negativen Grenzwert unterschreitet und die zweite Brückenspannung einen positiven Grenzwert überschreitet.

9. Verfahren nach Anspruch 7 oder 8, **dadurch gekennzeichnet, dass** das Verfahren zum Hochfahren des Energiebusses eingesetzt wird, wobei das Zuschalten der Busankoppelelemente (VBA, VBA1, ..., VBAn) sequentiell ausgehend von der Speisung erfolgt.

10. Verfahren nach einem der Ansprüche 7 bis 9, **dadurch gekennzeichnet, dass** das Verfahren während des Betriebs des Energiebusses eingesetzt wird, nachdem eine Störung im Betrieb, insbesondere ein Kurzschluss, und eine Isolierung des von der Störung im Betrieb betroffenen Bussegments im Energiebus festgestellt wurde.

11. Verfahren nach Anspruch 10, **dadurch gekennzeichnet,**
**dass**, die Störung im Betrieb durch Detektion einer Unterspannung an einem oder mehreren Verbraucher-Busankoppelelementen (VBA) detektiert wird,
**dass** bei den Verbraucher-Busankoppelelementen (VBA), bei denen die Unterspannung detektiert wurde, durch Öffnen der zweiten Schaltelemente (S2) der Verbraucher (FE) vom Energiebus automatisch getrennt wird, und
**dass** die Isolierung des von der Störung im Betrieb betroffenen Bussegments (BS') durch Öffnen der ersten Schaltelemente (S1) automatisch erfolgt.

12. Verfahren nach Anspruch 10 oder 11, **dadurch gekennzeichnet, dass** die Verbraucher (FE) während des Busaufbau-Verfahrens über lokale Energiespeicher (E) mit Energie versorgt werden.

13. Verfahren nach einem der Ansprüche 7 bis 12, **dadurch gekennzeichnet, dass** in Schritt d) ein Bussegment (BS) als zu überprüfendes Bussegment ausgewählt wird, das benachbart zum zuvor ausgewählten zu überprüfenden Bussegment ist.

14. Verfahren nach einem der Ansprüche 7 bis 13, **dadurch gekennzeichnet, dass** im Referenzbrückenzweig (RZ) temporär ein lokales Bezugspotential zur Erde geschaltet wird, vorzugsweise indem der mittlere Brückenwiderstand in zwei Brückenwiderstandselemente aufgeteilt und zwischen diesen Brückenwiderstandselementen ein weiteres Schaltelement (S3) gegen Erdpotential geschaltet ist.

15. Verfahren nach einem der Ansprüche 7 bis 14, **dadurch gekennzeichnet, dass** der Energiebus beidseitig mit Energie gespeist wird.

16. Verfahren nach Anspruch 15, **dadurch gekennzeichnet, dass** die Schritte a) - e) gleichzeitig für ein weiteres zu überprüfendes Bussegment durchgeführt werden, wobei die Prüfspannung an das zu überprüfende Bussegmente und an das weitere zu überprüfende Bussegment von verschiedene Richtungen innerhalb des Energiebusses angelegt wird.

17. Verfahren nach Anspruch 16, **dadurch gekennzeichnet, dass** die Versorgung des Weiteren zu überprüfenden Bussegments mit der Prüfspannung mittels einer zweiten Speisung (PS2) erfolgt.

18. Verfahren nach einem der Ansprüche 7 bis 17, **dadurch gekennzeichnet, dass** während des Betriebs des Energiebusses Isolationsmessungen mittels eines Isolationsüberwachungsgeräts an Leitungsabschnitten der Busleitung (L) durchgeführt werden, die mittels einer Diagnoseeinheit ferngesteuert werden, wobei Verbraucher (FE) innerhalb dieses Leitungsabschnitts in Betrieb bleiben.

## Claims

1. Energy supply device for supplying loads with energy, comprising
• an energy bus comprising a 2-pole bus line (L),
• bus coupling elements (SBA, SBA1, SBA2, VBA, VBA1, ..., VBAn), two bus coupling elements defining one bus segment, to be tested, of the bus line (L), and the bus coupling elements (SBA, SBA1, SBA2, VBA, VBA1, ..., VBAn) each comprising a first switching element pair comprising first switching elements (S1) for electrical isolation of the bus line (L), and
• a first supply (PS1), in particular a DC voltage source,
**characterized in that**
the bus coupling elements (SBA, SBA1, SBA2, VBA, VBA1, ..., VBAn) each comprise three bridge resistors (R_{B}) which are interconnected in series, between the positive potential side and the negative potential side of the bus line (L), and two bridging resistors (Rs) which each bridge one switching element (S1) of the first switching element pair,
in order to determine line faults, the energy supply device comprises a double Wheatstone bridge circuit comprising a reference bridge branch (RZ), a test bridge branch (PZ), and two indicator bridge branches (IZ),
in order to test the bus segment (BS) one of the bus coupling elements (SBA, SBA1, SBA2, VBA, VBA1, ..., VBAn) defining the bus segment to be tested functions as the reference bus coupling element (RBA), and the other functions as the test bus coupling element (PBA), the reference bridge branch (RZ) comprising the three bridge resistors (RB) of the reference bus coupling element (RBA), and the test bridge branch (PZ) comprising the three bridge resistors (R_{B}) of the test bus coupling element (PZ) and the bridging resistors (Rs) of the reference bus coupling element (PBA).

2. Device according to claim 1, **characterized in that** the loads (FE) are equipped with a local energy store (E), at least in part.

3. Device according to either of the preceding claims, **characterized in that** the bus line (L) is electrically connected to a further supply (PS2).

4. Device according to any of the preceding claims, **characterized in that** the central bridge resistor of the bridge resistors (R_{B}) connected in series has a higher resistance value than the two outside bridge resistors, in particular by a factor of 1.2 to 1.5.

5. Device according to any of the preceding claims, **characterized in that** an isolation monitoring device for performing isolation measurements on bus segments (BS) and/or the individual bus coupling elements (VBA, VBA1, ..., VBAn), and a diagnostic unit for controlling the isolation measurements, are present.

6. Device according to any of the preceding claims, **characterized in that** at least one load (FE) is connected to one of the bus coupling elements (VBA, VBA1, ..., VBAn), the loads (FE) preferably being components of control and command technology, in particular field elements, the loads (FE) each comprising a logic circuit or an operating processor.

7. Method for operating an energy supply device according to any of the preceding claims, the method comprising the following method steps:
a) selecting a bus segment to be tested, an operating voltage being applied to the reference bus coupling element (RBA) of the bus segment to be tested, and the first switching element (S1) of the reference bus coupling element (RBA) of the bus segment to be tested being opened, such that a test voltage that is reduced compared with the operating voltage is applied at the test bus coupling element (PBA);
b) measuring a first bridge voltage and a second bridge voltage of the double Wheatstone bridge circuit;
c) testing, on the basis of the measured bridge voltages, whether a fault is present;
d) if no fault is present:
the test bus coupling element (PBA) is connected to the energy bus in that the switching elements (S1) of the first switching element pair of the reference bus coupling element (RBA) are closed, and
steps a) - d) are repeated, a following bus segment (BS) being selected as the bus segment to be tested;
e) if a fault is present, the method is stopped, and thus the test bus coupling element (PBA) is not connected to the energy bus and no further bus segments (BS) are tested.

8. Method according to claim 7, **characterized in that**, in step c), a fault is identified if
i. the first bridge voltage and the second bridge voltage exceed a positive threshold value, or
ii. the first bridge voltage and the second bridge voltage fall below a negative threshold value, or
iii. the first bridge voltage falls below a negative threshold value and the second bridge voltage exceeds a positive threshold value.

9. Method according to either claim 7 or claim 8, **characterized in that** the method is used for starting up the energy bus, the connection of the bus coupling elements (VBA, VBA1, ..., VBAn) taking place sequentially, proceeding from the supply.

10. Method according to any of claims 7 to 9, **characterized in that** the method is used during operation of the energy bus, after a fault during operation, in particular a short circuit, and isolation of the bus segment, in the energy bus, affected by the fault during operation, has been identified.

11. Method according to claim 10, **characterized in that**
the fault is detected during operation by detection of an undervoltage at one or more load-bus coupling elements (VBA),
in the case of the load-bus coupling elements (VBA) in which the undervoltage was detected, the load (FE) is automatically separated from the energy bus by opening the second switching elements (S2), and
the isolation of the bus segment (BS') affected by the fault during operation is achieved automatically, by opening the first switching elements (S1).

12. Method according to either claim 10 or claim 11, **characterized in that** the loads (FE) are supplied with energy by means of local energy stores (E) during the bus set-up process.

13. Method according to any of claims 7 to 12, **characterized in that**, in step d), a bus segment (BS) is selected as the bus segment to be tested, which is adjacent to the previously selected bus segment to be tested.

14. Method according to any of claims 7 to 13, **characterized in that** a local reference potential is temporarily switched to ground in the reference bridge branch (RZ), preferably **in that** the central bridge resistor is divided into two bridge resistor elements, and, between said bridge resistor elements, a further switching element (S3) is switched against ground potential.

15. Method according to any of claims 7 to 14, **characterized in that** the energy bus is supplied with energy from both sides.

16. Method according to claim 15, **characterized in that** steps a) - e) are performed simultaneously for a further bus segment to be tested, the test voltage being applied to the bus segments to be tested and to the further bus segment to be tested, from different directions within the energy bus.

17. Method according to claim 16, **characterized in that** the further bus segment to be tested is supplied with the test voltage by means of a second supply (PS2).

18. Method according to any of claims 7 to 17, **characterized in that**, during operation of the energy bus, isolation measurements are performed on line portions of the bus line (L) by means of an isolation monitoring device, which line portions are controlled remotely by means of a diagnostic unit, the loads (FE) within said line portion remaining in operation.

## Revendications

1. Dispositif d'alimentation en énergie conçu pour alimenter en énergie des appareils consommateurs, comprenant
• un bus de puissance, muni d'une ligne de bus (L) à 2 pôles,
• des éléments (SBA, SBA1, SBA2, VBA, VBA1, ..., VBAn) de couplage de bus, sachant que deux éléments de couplage de bus délimitent un segment de bus de ladite ligne de bus (L) devant être contrôlé, et sachant que lesdits éléments (SBA, SBA1, SBA2, VBA, VBA1, ..., VBAn) de couplage de bus incluent, à chaque fois, une première paire d'éléments de commutation dotée de premiers éléments de commutation (S1) affectés au sectionnement électrique de ladite ligne de bus (L), et
• un premier approvisionnement (PS1), en particulier une source de tension continue,
**caractérisé**
**par le fait que** les éléments (SBA, SBA1, SBA2, VBA, VBA1, ..., VBAn) de couplage de bus incluent, à chaque fois, trois résistances de pont (R_{B}) branchées mutuellement en série entre un côté potentiel positif et un côté potentiel négatif de la ligne de bus (L), et deux résistances de pontage (R_{S}) respectivement montées en dérivation d'un élément de commutation (S1) de la première paire d'éléments de commutation ;
**par le fait que** ledit dispositif d'alimentation en énergie présente, en vue de spécifier des perturbations de ligne, un branchement en double pont de Wheatstone comportant une branche de pont de référence (RZ), une branche de pont de test (PZ) et deux branches de pont d'indication (IZ) ; et
**par le fait que**, pour contrôler le segment de bus (BS), l'un des éléments (SBA, SBA1, SBA2, VBA, VBA1, ..., VBAn) de couplage de bus, délimitant ledit segment de bus à contrôler, remplit une fonction d'élément de couplage de bus de référence (RBA), et l'autre, une fonction d'élément de couplage de bus de test (PBA), sachant que la branche de pont de référence (RZ) inclut les trois résistances de pont (R_{B}) dudit élément de couplage de bus de référence (RBA), et sachant que la branche de pont de test (PZ) inclut les trois résistances de pont (R_{B}) dudit élément de couplage de bus de test (PBA), ainsi que les résistances de pontage (R_{S}) dudit élément de couplage de bus de référence (RBA).

2. Dispositif selon la revendication 1, **caractérisé par le fait que** les appareils consommateurs (FE) sont équipés, au moins en partie, d'un accumulateur local d'énergie (E).

3. Dispositif selon l'une des revendications précédentes, **caractérisé par le fait que** la ligne de bus (L) est connectée électriquement à un approvisionnement additionnel (PS2).

4. Dispositif selon l'une des revendications précédentes, **caractérisé par le fait que** la résistance de pont médiane, au sein des résistances de pont (R_{B}) branchées en série, présente une plus grande valeur résistive que les deux résistances de pont extérieures, en particulier d'un facteur de 1,2 à 1,5.

5. Dispositif selon l'une des revendications précédentes, **caractérisé par** la présence d'un appareil de surveillance d'isolement, dédié à l'exécution de mesures d'isolement sur des segments de bus (BS) et/ou sur les éléments individuels (VBA, VBA1, .., VBAn) de couplage de bus, et d'une unité de diagnostic conçue pour commander lesdites mesures d'isolement.

6. Dispositif selon l'une des revendications précédentes, **caractérisé par le fait qu'**au moins un appareil consommateur (FE) est connecté à l'un des éléments (VBA, VBA1, ..., VBAn) de couplage de bus, les appareils consommateurs (FE) se présentant, de préférence, comme des composants de la technologie de contrôle et de commande, en particulier comme des éléments de terrain, lesdits appareils consommateurs (FE) incluant, à chaque fois, une logique et un processeur d'exploitation.

7. Procédé d'actionnement d'un dispositif d'alimentation en énergie conforme à l'une des revendications précédentes, ledit procédé incluant les étapes opératoires suivantes, consistant à :
a) sélectionner un segment de bus à contrôler, sachant qu'une tension de service est appliquée à l'élément de couplage de bus de référence (RBA) dudit segment de bus à contrôler, et sachant que les premiers éléments de commutation (S1) dudit élément de couplage de bus de référence (RBA) du segment de bus à contrôler sont ouverts de telle sorte qu'une tension de test, réduite par rapport à ladite tension de service, soit appliquée à l'élément de couplage de bus de test (PBA) ;
b) mesurer une première tension de pont et une seconde tension de pont du branchement en double pont de Wheatstone ;
c) contrôler, en fonction des tensions de pont mesurées, si une perturbation se présente ;
d) en l'absence de perturbation :
l'élément de couplage de bus de test (PBA) est mis en circuit avec le bus de puissance, par fermeture des éléments de commutation (S1) de la première paire d'éléments de commutation de l'élément de couplage de bus de référence (RBA), et
les étapes a) - d) sont réitérées, un segment de bus (BS) successif étant alors sélectionné pour constituer le segment de bus à contrôler ;
e) en présence d'une perturbation, le procédé est arrêté de telle sorte que l'élément de couplage de bus de test (PBA) ne soit pas mis en circuit avec le bus de puissance, et qu'il ne s'opère aucun contrôle de segments de bus (BS) supplémentaires.

8. Procédé selon la revendication 7, **caractérisé par le fait qu'**une perturbation est constatée, à l'étape c), lorsque
i. la première tension de pont et la seconde tension de pont excèdent une valeur limite positive, ou
ii. ladite première tension de pont et ladite seconde tension de pont se situent en deçà d'une valeur limite négative, ou
iii. lorsque ladite première tension de pont se situe en deçà d'une valeur limite négative, et ladite seconde tension de pont excède une valeur limite positive.

9. Procédé selon la revendication 7 ou 8, **caractérisé par le fait que** ledit procédé est utilisé pour démarrer le bus de puissance, la mise en circuit des éléments (VBA, VBA1, ..., VBAn) de couplage de bus ayant lieu séquentiellement à partir de l'approvisionnement.

10. Procédé selon l'une des revendications 7 à 9, **caractérisé par le fait que** ledit procédé est utilisé, au cours du fonctionnement du bus de puissance, après constatation d'une perturbation en service, d'un court-circuit en particulier, et d'un isolement du segment de bus concerné par ladite perturbation en service dans ledit bus de puissance.

11. Procédé selon la revendication 10, **caractérisé par le fait que** la perturbation en service est détectée par détection d'une sous-tension sur un ou plusieurs élément(s) (VBA) de couplage de bus d'appareil(s) consommateur(s),
que, dans les éléments (VBA) de couplage de bus d'appareils consommateurs dans lesquels ladite sous-tension a été détectée, l'appareil consommateur (FE) est déconnecté automatiquement d'avec le bus de puissance par ouverture des deuxièmes éléments de commutation (S2), et
que l'isolement du segment de bus (BS') concerné par ladite perturbation en service s'opère automatiquement, par ouverture des premiers éléments de commutation (S1).

12. Procédé selon la revendication 10 ou 11, **caractérisé par le fait que** les appareils consommateurs (FE) sont alimentés en énergie, au cours du procédé de configuration du bus, par l'intermédiaire d'accumulateurs locaux d'énergie (E).

13. Procédé selon l'une des revendications 7 à 12, **caractérisé par le fait qu'**un segment de bus (BS), voisin du segment de bus à contrôler préalablement sélectionné, est sélectionné à l'étape d) en tant que segment de bus à contrôler.

14. Procédé selon l'une des revendications 7 à 13, **caractérisé par le fait qu'**un potentiel local de référence par rapport à la terre est commuté temporairement dans la branche de pont de référence (RZ), de préférence en scindant la résistance de pont médiane en deux éléments de résistance de pont et en connectant, entre ces éléments de résistance de pont, un élément de commutation supplémentaire (S3) au potentiel de terre.

15. Procédé selon l'une des revendications 7 à 14, **caractérisé par le fait que** le bus de puissance est alimenté en énergie des deux côtés.

16. Procédé selon la revendication 15, **caractérisé par le fait que** les étapes a) - e) sont exécutées en simultanéité pour un segment de bus supplémentaire à contrôler, la tension de test étant appliquée au segment de bus à contrôler, et audit segment de bus supplémentaire à contrôler, à partir de directions différentes à l'intérieur du bus de puissance.

17. Procédé selon la revendication 16, **caractérisé par le fait que** l'alimentation du segment de bus supplémentaire à contrôler, par la tension de test, a lieu au moyen d'un second approvisionnement (PS2).

18. Procédé selon l'une des revendications 7 à 17, **caractérisé par le fait que**, durant le fonctionnement du bus de puissance, des mesures d'isolement sont effectuées, au moyen d'un appareil de surveillance d'isolement, sur des tronçons de la ligne de bus (L) qui sont commandés à distance au moyen d'une unité de diagnostic, des appareils consommateurs (FE) demeurant en service à l'intérieur de ce tronçon de ligne.
